## Europäisches Patentamt
## European Patent Office
## Office européen des brevets

(19)

(11) Numéro de publication: **0 070 225 B1**

(12) ## FASCICULE DE BREVET EUROPEEN

(45) Date de publication du fascicule du brevet:
**23.10.85**

(51) Int. Cl.⁴: **G 01 R 31/28**

(21) Numéro de dépôt: **82401249.6**

(22) Date de dépôt: **02.07.82**

(54) **Dispositif support de circuits intégrés utilisé dans un système de sélection de circuits intégrés à haute fiabilité.**

(30) Priorité: **10.07.81 FR 8113681**

(43) Date de publication de la demande:
**19.01.83 Bulletin 83/3**

(45) Mention de la délivrance du brevet:
**23.10.85 Bulletin 85/43**

(84) Etats contractants désignés:
**DE GB IT NL SE**

(56) Documents cités:
**US - A - 3 609 547**
**US - A - 3 656 058**
**US - A - 3 842 346**
**US - A - 4 145 620**

**(ELECTRONIQUE INDUSTRIELLE ET MICROELECTRONIQUE, no. 130, janvier-février 1970, page 60, Paris (FR); "Carte de câblage à tout faire" IBM TECHNICAL DISCLOSURE BULLETIN, vol. 21, no. 6, novembre 1978, pages 2277,2278, Armonk (USA); R.L. HESTER et al.: "Module tester"**

(73) Titulaire: **THOMSON-CSF, 173, Boulevard Haussmann, F-75379 Paris Cedex 08 (FR)**

(72) Inventeur: **Charruau, Stéphane, THOMSON-CSF SCPI 173, bld Haussmann, F-75379 Paris Cedex 08 (FR)**

(74) Mandataire: **Trocellier, Roger et al, THOMSON-CSF SCPI 173, Bld Haussmann, F-75379 Paris Cedex 08 (FR)**

BUNDESDRUCKEREI BERLIN

## Description

La présente invention concerne un dispositif support de circuits intégrés utilisé dans un système de sélection de circuits intégrés à haute fiabilité, la sélection étant opérée en fonction de contraintes sévères prédéterminées, thermiques et dynamiques. Un tel ensemble est encore appelé système de déveriminage climatique et dynamique (dynamic burn-in-testing selon l'appellation anglosaxonne). Un équipement de ce genre est utilié pour produire un vieillissement accéléré des composants entraînant la panne pour ceux qui s'avèrent inaptes à supporter les contraintes exigées et consécutivement, la sélection des autres composants répondant aux normes désirées et que permettront ensuite de réaliser des équipements présentant un taux de défaillance minime et donc une haute fiabilité.

On entend par dispositif support de circuits intégrés l'ensemble des plateaux prévus à ce qui sont disposés dans une étuve pour subir certaines contraintes de fonctionnement à température élevée et qui d'autre part reçoivent un certain nombre de signaux dynamiques de circuits générateurs de signaux extérieurs à l'étuve. Un plateau support de circuits intégrés est essentiellement un circuit imprimé de grandes dimensions capable de supporter des températures extrêmes élevées par exemple de −55°C à +125°C, équipé de supports soudés sur le circuit imprimé destiné à recevoir les circuits intégrés que l'on veut sélectionner. Le circuit imprimé est tel que l'on accepte sur un même plateau que des circuits intégrés d'un même type et que les broches correspondantes de même numéro sont câblées en parallèle.

Suivant des réalisation connues, le câblage en parallèle est assuré par une carte mère et des cartes filles implantées verticalement sur la carte mère. Les cartes filles restent spécialisées par type de circuit intégré et le montage ne permet de traiter que sept signaux au maximum transmis aux circuits intégrés.

Un premier inconvénient résulte du nombre élevé de plateaux différents nécessaires pour couvrir les différentes gammes de circuits intégrés existants. En dehors de quelques réalisations spécifques et particulières, les circuits intégrés peuvent être divisés en trois types à partir du brochage. Le pas des broches reste standard, de 1/10 de pouce, ce qui correspond à 2,54 mm mais l'écartement entre les deux rangées de broche présente trois valeurs, une première de 3/10 de pouce soit 7,62 mm pour les circuits ayant jusqu'à 20 broches, une seconde de 4/10 de pouce soit 10,16 mm pour les circuits ayant 22 broches, et une troisième valeur de 6/10 de pouce soit 15,24 mm pour les circuits ayant plus de 22 broches. De manière à simplifier le texte et faciliter la lecture, les dimensions de pas et d'écartement entre rangées sont seulement précisées dans ce qui suit selon la terminologie usuelle dans le domaine, c'est-à-dire en dixièmes de pouces.

Les exigences des utilisateurs conduisant également à une multiplication sans fin des plateaux en fonction des cahiers des charges désirés par les utilisateurs.

Les plateaux existants présentent encore d'autres limitations, notamment dans le cadre de la protection individuelle des circuits intégrés pour laquelle les cartes filles ne sont guère dotées que d'éléments résistifs de limitation de courant selon des réalisations connues.

Le but de l'invention est de remédier aux inconvénients des techniques actuelles en réalisant un dispositif support de circuits intégrés qui présente une structure universelle autorisant des applications faciles et économiques dans le cadre d'une grande variété de circuits intégrés devant être sélectionnés. L'invention vise à assurer la continuité du travail de sélection jusqu'à son terme avec le maximum d'efficacité grâce à l'excitation intégrale de toutes les broches, et de sécurité à la première défaillance des alimentations ou d'un circuit intégré. L'investissement dans le magasin de plateaux est réduit, le passage d'un lot de circuit intégré à un autre pour la sélection est facilité, la gestion du magasin des plateaux est aisée.

Un objet de la présente invention et de réaliser un dispositif support universel de circuits intégrés constitué par un unique modèle de plateau pour recevoir respectivement les circuits intégrés qui présentent des écarts de 0,3, 0,4 et 0,6 pouce; il en résulte une topoligie unique de la carte mère qui aboutit à une économie d'investissement pour l'utilisateur. Pour les cartes filles il n'y a également qu'un modèle ce qui contribue encore à l'aspect économique et les cartes filles remplissent de nombreux rôles qui sont les suivants:

— distribution de l'énergie électrique et des signaux par sous-groupe de circuits intégrés sur la totalié des broches des circuits intégrés,
— isolement et protection individuelle des circuits intégrés contre le défaut de court circuit sur une broche quelconque d'un circuit défectueux en cours de sélection,
— protection contre les surtensions transitoires d'origine externe, positives ou négatives,
— proctection contre l'accrochage des oscillations parasites,
— enfin adaptation du plateau à toutes les sortes de brochage des alimentations et des signaux entrée-sortie des circuits intégrés connus présentement grâce à un ensemble de cavaliers enfichables.

Les particularités de la présente invention apparaîtront dans la description qui suit donnée à titre d'exemple non limitatif, à l'aide des figures annexées qui représentent:

Figure 1, un diagramme d'un système de sélection de circuits intégrés utilisant un dispositif support conforme à la présente invention;

Figure 2, un schéma d'un exemple de réalisation du plateau support de circuits intégrés;

Figure 3 à Figure 8, des schémas relatifs à un exemple de réalisation de la carte mère du plateau support selon l'invention;

Figure 9, une représentation de la connectique du modèle unique de carte fille utilisée suivant l'exemple de réalisation du dispositif support des Figures 6 à 8.

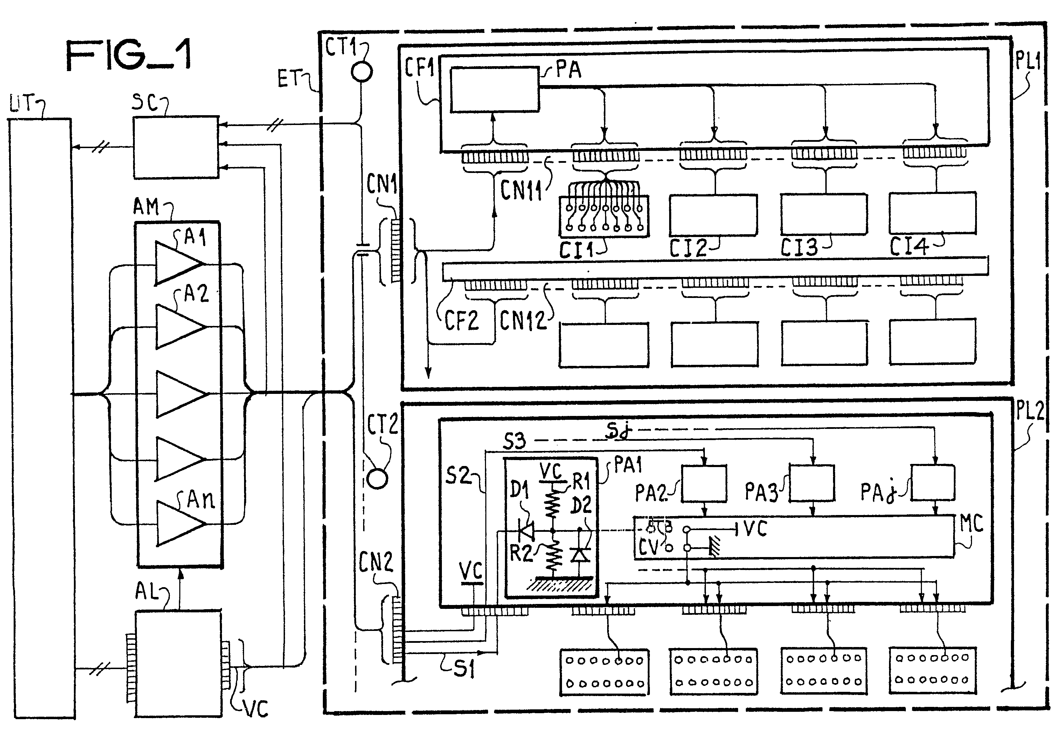

Les plateaux supports, objet de l'invention, ont été représentés sur la Figure 1 dans le cadre de leur utilisation dans un système de sélection de circuits intégrés afin de mieux mettre en évidence les caractéristiques et les motivations correspondantes. Les plateaux $PL_1$, $PL_2$, etc. . . sont disposés dans une étuve ET pour y subir des contraintes thermiques prédéterminées. Chaque plateau comporte une pluralité de cartes fille $CF_1$, $CF_2$, etc. . . Chaque carte fille est associée à une pluralité de circuits intégrés $CI_1$, $CI_2$, etc. . . La partie restante du système comporte une unité de traitement et de programmation UT, des circuits d'alimentation AL, un ensemble AM d'amplificateurs ($A_1$ à $A_n$) générateur de signaux dynamiques, des circuits de sécurité SC et des capteurs de températures $CT_1$, $CT_2$, etc. . . placés dans l'étuve ET. L'unité de traitement UT gère l'ensemble et est programmée en fonction du cahier des charges à assumer pour les circuits intégrés à sélectionner. Les signaux fournis par l'ensemble de sécurité SC permet le contrôle du bon fontionnement de l'unité climatique ET et de l'ensemble des circuits AM générateur de signaux dynamiques et ceux AL d'alimentation.

Les signaux dynamiques et les signaux d'alimentation (incluant le potentiel masse de référence) sont transmis respectivement en parallèle aux différents plateaux situés dans l'étuve. Ces signaux sont reçus sur chaque plateau au moyen d'un connecteur de raccordement $CN_1$, $CN_2$ etc. . . généralement formé par une prise solidaire du plateau enfichable sur une embase solidaire de l'étuve. Le plateau comporte une carte mère et les cartes filles pour réaliser l'interconnexin en parallèle des signaux reçus vers les différentes broches des circuits intégriés respectifs, les broches de même numéro recevant le même signal. Ceci est réalisé par les circuits imprimés de la carte mère et des cartes filles. Le circuit imprimé de la carte mère permet de raccorder en parallèle le connecteur d'entrée du plateau aux différentes cartes filles, ainsi que les connexions allant des cartes filles aux broches des circuits intégrés. Chaque carte fille assure la redistribution des signaux en parallèle suivant autant de voies qu'il y a de circuits intégrés associés à la carte fille; dans l'exemple figuré le nombre de circuits intégrés associés $CI_1$ à $CI_4$ a été limité à quatre. Cette distribution en parallèle par les cartes filles est faite par l'intermédiaire d'un circuit de protection et d'adaptation PA. Les interconnexions entre la carte mère et les cartes filles correspondantes s'effectuent par l'intermédiare d'un connecteur, $CN_{11}$ pour la carte fille $CF_1$, $CN_{12}$ pour la carte $CF_2$ etc. . . constitué par une embase solidaire de la carte mère sur laquelle vient s'enficher une prise solidaire de la carte fille. Chacun de ces connecteurs, tel $CN_{11}$ comporte un groupement de broches d'arrivée en nombre égal à celui du connecteur de raccordement extérieur $CN_1$ correspondant et quatre groupements de broches de sorties pour alimenter à travers le circuit imprimé de la carte mère les broches respectives des circuits intégrés associés $CI_1$ à $CI_4$.

Une première originalité du dispositif est que toutes les broches des circuits intégrés peuvent être alimentées ce qui impose, en particulier, un nombre correspondant d'amplificateurs générateurs de signaux dynamiques. Une autre particularité mise en évidence sur le détail de la représentation du plateau $PL_2$ est que la transmission en parallèle d'un signal dynamique, tel $S_1$, sur les broches de même numéro des circuits intégrés supportés par le plateau, s'effectue à travers un circuit de protection et d'adaptation élémentaire $PA_1$, l'ensemble PA étant subdivisé en autant de circuits de protection et d'adaptation élémentaires qu'il y a de connexions de signaux dynamiques à réaliser.

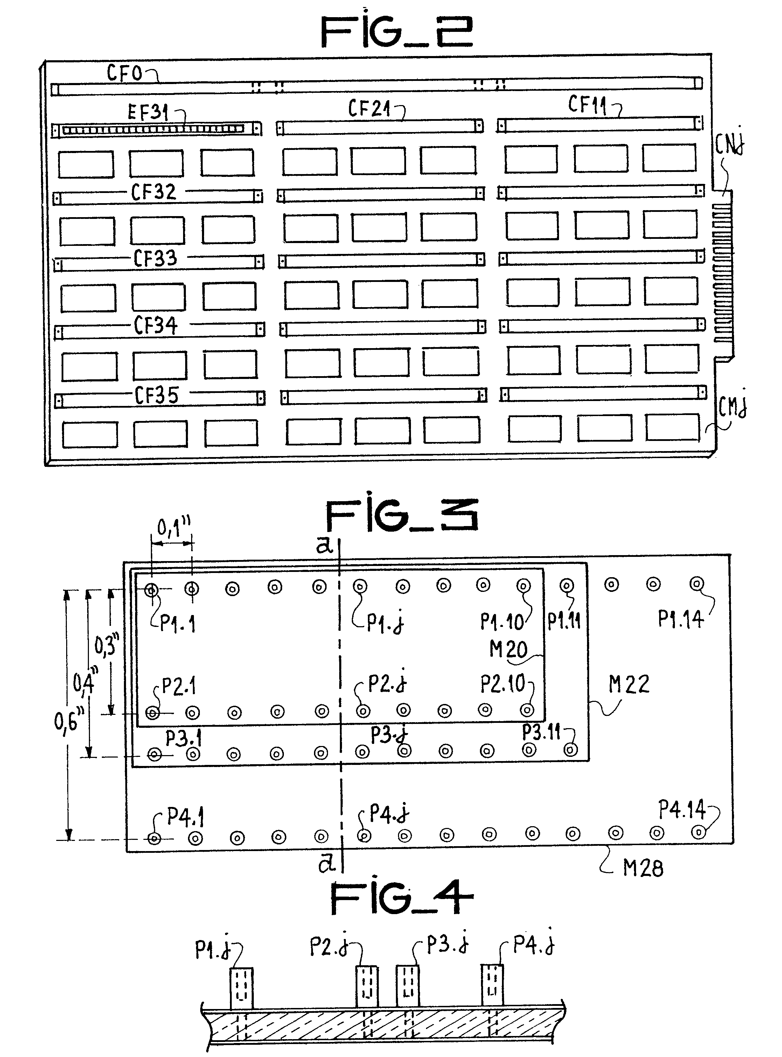

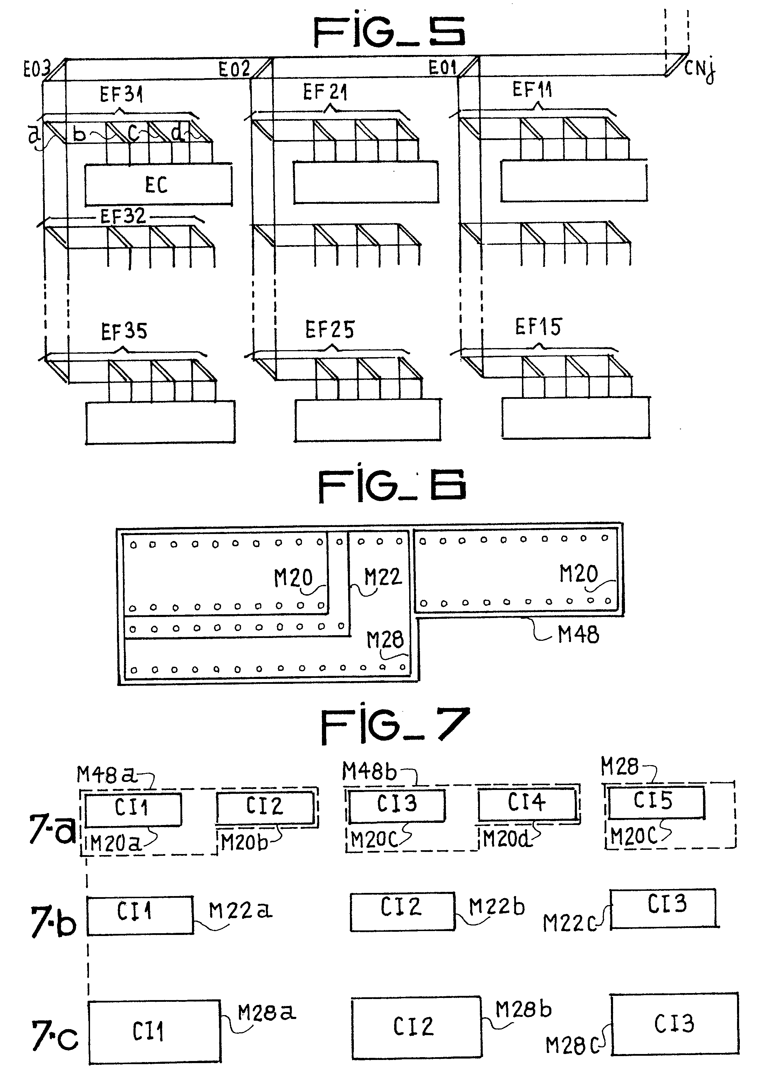

Suivant l'invention, le dispositif support est réalisé selon un unique modèle de plateau dont un exemple est représente sur la Figure 2, équipé de cartes filles CFij, et de circuits intégrés. Selon cet exemple, il supporte quinze cartes filles réparties en trois groupes, chaque carte fille associée à trois circuits intégrés ce qui permet de traiter quarante cinq circuits. L'une des cartes filles, la première CF31 du troisième groupe, a été otée pour montrer une embase de raccordement EF31 correspondante. La carte mère CMj reste réalisée avec une structure en circuit imprimé double face tandis que les cartes filles CFij sont en circuit multicouches ayant au moins trois couches répondre aux besoins de la connectique à satisfaire. La face arrière non visible correspond à la face portant les soudures du circuit imprimé de la carte mère et qui pourvoit aux interconnexions et aux raccordement entre le connecteur CNj de raccordement extérieur et les prises des embases EFij support des cartes filles ainsi que, entre ces embases et les moyens support de circuits intégrés ceci par l'intermédiaire de trous métallisés selon des techniques conventionnelles. L'élément CFO à la partie supérieure correspond à une carte fille, dite omnibus, qui assure la distribution des connexions venant de CNj respectivement vers les trois groupes de cartes filles. La carte fille omnibus CFO permet de distribuer ainsi les stimuli et les alimentations venant de CNj parmi les cartes filles CFij; elle est associée à trois embases de raccordement EO1, EO2, EO3 montées sur la carte mère et indiquées sur la Figure 5. Le support EO1 reçoit les signaux et alimentations venant du connecteur CNj et les redistribue directement vers un premier groupe de cartes filles CF11 à CF15 liées aux embases EF11 à EF15 et indirectement par l'intermédiaire de la carte fille omnibus et des embases EO2 et OE3, vers le deuxième et troisième groupes de cartes filles, respectivement CF21 à CF25 et CF31 à CF35.

Du point de vue de l'interprétation le schéma simplifié de la Figure 5 montre les connexions du circuit imprimé de la carte mère ainsi que le circuit imprimé des cartes filles, ce dernier est constitué par la mise en parallèle des éléments référencés a, b, c, d formant une embase de carte fille. Le raccordement des parties b, c, d aux circuits intégrés associés s'effectue à travers une connectique particulière EC qui fait partie du circuit imprimé de la carte mère. Les différentes cartes du plateau; carte mère, cartes filles et carte omnibus, sont constituées avec des matériaux à haute tenue en température et peu hydroscopiques.

Une particularité du dispositif support tient en la réalisation des supports de connexion de circuits intégrés. La Figure 3 représente le modèle de base utilisé pour l'obtention de cette connectique particulière permettant d'accepter les différents boîtiers de circuits intégrés et n'avoir qu'un modèle de plateau. Cette connectique EC remplace les embases support traditionnelles de circuits intégrés, qu'elles soient du type haut profil ou bas profil, conventionellement utilisées pour les opérations de déverminage et qui sont spécialisées en fonction du nombre de broches et la longueur de boîtiers des circuits intégrés. La connectique EC utilise comme élément de base pour l'insertion de chaque broche d'un circuit intégré une prise femelle dont le profil interne est tronconique, du type dit à tulipe. Ces prises femelles sont destinées à recevoir les broches des circuits intégrés et réparties selon quatre rangées parallèles suivant le dessin de la Figure 3. Dans chaque rangée les prises sont distantes au pas standard de 0,1 pouce. L'espacement entre les différentes rangées correspond aux trois différentes valeurs à produire 0,3–0,4 et 0,6 pouce. La première rangée comporte quatorze prises femelles P1.1 à P1.14 pour pouvoir être associées soit avec les dix prises de la deuxième rangée P2.1 à P2.10, soit avec les onze prises de la troisième rangée P3.1 à P3.11, soit encore avec les quatorze prises de la quatrième rangée P4.1 à P4.14. On a ainsi constitué trois modules répondant aux divers besoins: un module M20, formé par les prises P1.1 à P1.10 et P2.1 à P2.10 pour la réception de circuits ayant au maximum 20 broches, ensuite un module M22 formé par P1.1 à P1.11 et P3.1 à P3.11 pour le test des circuits ayant 22 broches et le plus grand module M28 pour la sélection de circuits ayant de 24 à 28 broches, ce module comportant les broches P1.1 à P1.14 et P4.1 à P4.14.

Sur la Figure 4 que représente une coupe partielle selon aa de la structure précédente, on se rend compte de manière plus précise de la constitution des prises femelles du type à tulipe déterminées pour recevoir chacune dans leur partie externe au circuit imprimé une broche du circuit intégré et dont la partie interne est un axe soudé au circuit de la carte mère à travers un trou métallisé.

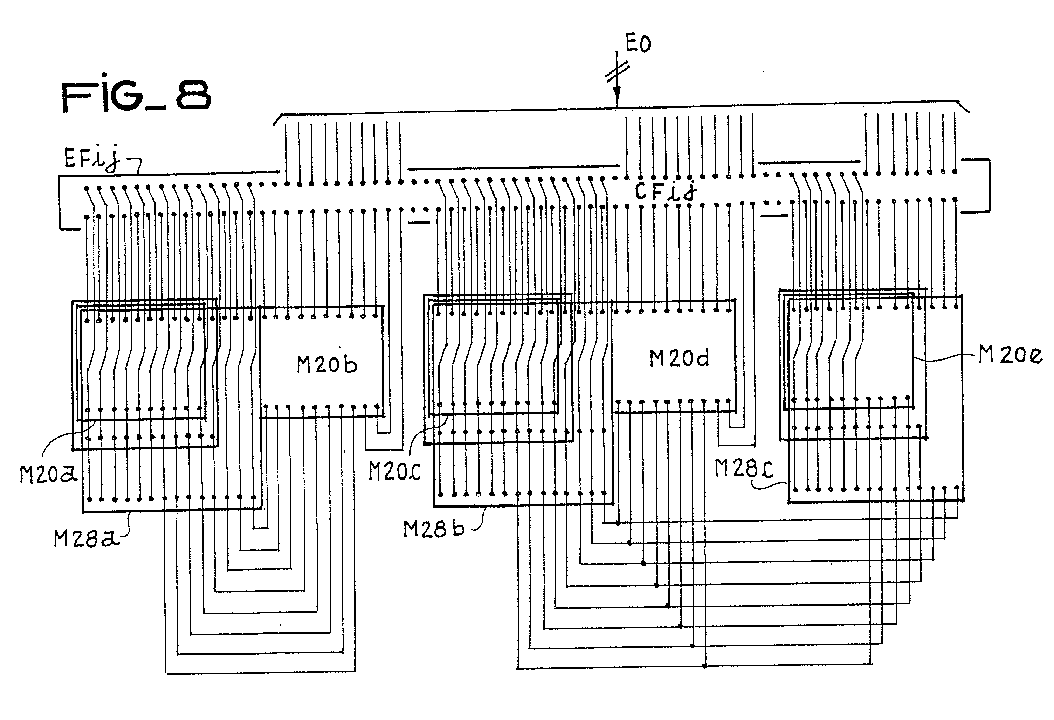

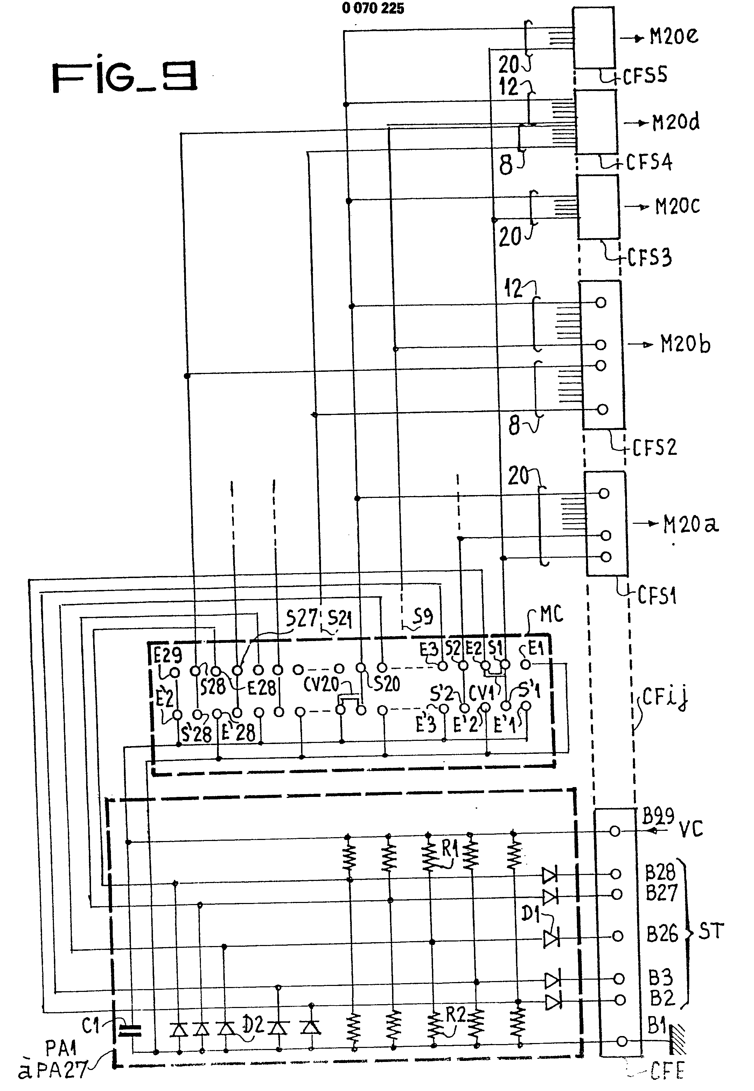

Selon un exemple de réalisation, la connectique EC associée à chacune des cartes filles se compose de plusieurs modules agencés selon les Figures 6 et 7. La figure 6 montre un module M48 réalisé à partir d'un module M28 précédemment décrit auquel est adjoint un module M20. La connectique EC comporte, représenté sur la Figure 7A, deux modules M48. Ces trois modules sont distribuées de sorte que les rangées correspondantes sont alignées. Selon cette réalisation il est possible de tester cinq circuits ayant au plus 20 broches comme le montre la Figure 7a, ou trois circuits ayant 22 broches (Figure 7b), ou trois circuits ayant 24 à 28 broches (Figure 7c). Le circuit imprimé d'interconnexion aboutissant aux prises Pk.j peut être conçu en sorte que des prises de la première rangée reçoivent les stimuli ou alimentations de numéro pair par exemple. Les prises de même rang des autres rangées sont connectées ensemble et ces prises reçoivent les stimuli ou alimentations de numéro impair. La réalisation de ces interconnexions exige un compromis entre la limitation du nombre de couches de la carte mère à deux, la recherche de la surface minimale pour les cartes filles pour assurer une densité maximel de remplissage de l'étuve, la limitation du nombre de couches des cartes filles à cinq pour des raisons de coût, la recherche de la longueur optimale du support de raccordement EFij des cartes filles en liaison avec la longueur d'une rangée de circuits intégrés attribués à la carte fille. Ce compromis a été satisfait suivant cet exemple de réalisation comme détaillé sur la Figure 8 par le démultiplexage des huit derniers signaux sur le circuit imprimé de la carte mère, les autres signaux étant démultiplexés sur le circuit imprimé de la carte fille représenté sur la Figure 9. Les prises de la première rangée reçoivent les stimuli, ou alimentations de numéro pair par exemple, tandis que les prises de même rang des autres rangées, c'est-à-dire les deuxième, troisième et quatrième rangées de prises de raccordement des circuits sont connectées ensemble par le circuit imprimé de la carte mère et reçoivent les stimuli ou alimentations de numéro impair. Il a été utilisé également un artifice d'interconnexion sur la carte mère, les huit derniers signaux de la quatrième rangée du module M28 des deux premiers ensembles M48a et M48b sont reliés aux huit bornes de la deuxième rangée du module M20 qui suit ainsi que, pour la dernière liaison, également aux huit dernières bornes de la quatrième rangée du module M28c qui termine l'ensemble. Ceci permet d'économiser des broches sur le support de raccordement EFij lesquelles sont disponibles pour la réception de signaux venant du connecteur EO correspondant de la carte omnibus CFO.

Dans les différents cas d'utilisation selon les différents boîtiers, on exploite au plus 28 signaux (26 stimulis, une tension d'alimentation continue VC, et un raccordement à la masse) venant de chaque carte fille CFij, mais du fait de l'artifice d'interconnexions évoqué, les huit derniers signaux de rang 21 à 28 inclus sont identiques aux huit premiers de rang 1 à 8 inclus, pour les circuits de largeur 0,3 pouce dont le nombre de broches est égal ou inférieur à 20. Les signaux de rang 1 à 20 arrivent directement sur les circuits 0,3 pouce correspondant aux modules indiqués M20a, M20c et M20e sur la Figure 8, tandis que les signaux de rang 9 à 28 arrivent directement sur les circuits 0,3 pouce M20b et M20d. En ce qui concerne les circuits 0,4 et 0,6 pouce, les signaux de rang 1 à 28 arrivent directement sur ces circuits au nombre de trois. L'identité nécessaire des signaux de rang 21 à 28 par rapport aux signaux de rang 1 à 8 pour les circuits en 0,3 pouce est assurée outre par l'artifice d'interconnexion, par programmation du logiciel de sélection. Un avantage complémentaire de la connectique EC concerne l'utilisation directe des plateaux à la sélection des circuits intégrés hybrides ayant des boîtiers particuliers.

La capacité d'un plateau à structure universelle selon la réalisation indiquée est de 75 circuits en 0,3 pouce et de 45 circuits en 0,4 ou 0,6 pouce; le connecteur externe CNj et les supports EO1 à EO3 comportent 29 points actifs pour la transmission des stimuli et des alimentations.

La Figure 9 représente le circuit d'une carte fille dans le contexte de réalisation précédemment décrit selon les Figures 7 et 8. La carte fille comporte un connecteur CFij à 130 points muni de 29 entrées et de 100 sorties pour alimenter respectivement les circuits intégrés à travers l'embase EFij et le circuit imprimé de la carte mère. Le connecteur CFij se trouve ainsi décomposé en une partie CFE recevant les signaux d'entrée et en cinq parties CFS1 à CFS5 pour transmettre les signaux aux circuits intégrés. La partie CFE comporte 29 bornes B1 à B29, une entrée d'alimentation positive +VC sur la borne B29, une borne B1 de raccordement à la masse ou à une alimentation négative, et 27 bornes d'arrivée B2 à B28 des signaux dynamiques ou stimuli. Ces signaux d'arrivée stimuli et alimentations sont raccordés à travers les circuits de protection et d'adaptation PA1 à PA27 et à travers une matrice de commutation CM aux différents connecteurs de sortie CFS1 à CFS5.

Les circuits de protection et d'adaptation remplissent les fonctions principales suivantes: isolement des circuits intégrés par groupe lié à une carte fille, c'est-à-dire qu'en cas d'accident dû à un court-circuit franc sur l'un des circuits intégrés associé à la carte fille CFij, seul ce groupement de circuits intégrés se trouve concerné par le court-circuit et non les autres groupements de circuits intégrés qui sont alimentés respectivement par les autres cartes filles; protection contre des transitoires positives ou négatives excédant la tension d'alimentation continue VC; protection contre l'accrochage des oscillations parasites liées à l'inductance parasite de la liaison externe au plateau.

Le circuit PA se compose de 27 circuits identiques comportant chacun comme représenté pour celui ayant trait à la borne B20 de deux diodes D1 et D2 et de deux résistances R1 et R2 qui sont dans le rapport R2/R1 = 10. Le pont de résistances impose aux bornes de R2 un potentiel de l'ordre de 0,9 fois VC qui est interprêté comme un niveau logique »1«.

Si le potentiel sur l'une quelconque des broches devient supérieur à cette valeur 0,9 VC, la diode D1 se trouve mise à l'état bloqué et le montage assure donc la protection contre les surtensions positions parvenant sur la broche en question.

Si le potentiel sur l'une quelconque des broches de CFE devient égal au niveau de référence, c'est-à-dire la masse, alors la diode D1 conduit et impose cette fois avec le pont de résistances R1—R2, un potentiel de bas niveau de l'ordre de 0,7 volt interprêté comme niveau logique »0« par le système.

Au cas où le potentiel devient inférieur à celui de la masse sur l'une des broches de CFE, la diode D2 se met alors à conduire en série avec la diode D1, protégeant les entrées correspondantes des circits intégrés reliées à la broche en question.

En cas de présence d'une inductance parasite en série avec l'une des broches de CFE la capacité inverse de la diode D2 associée à la valeur des deux résistances R1 et R2 mises en parallèle représente une cellule de filtrage de fréquence de coupure de l'ordre de 100 MHz environ, c'est-à-dire un filtrage passe-bas, qui est efficace pour des valeurs d'inductance inférieures au microhenry. Les liaisons externes au plateau doivent être courtes ou blindées.

Le circuit PA comporte en outre un condensateur de découplage C1 de la tension d'alimentation +VC.

La matrice de commutation des stimuli et des alimentations MC est contituée par une double rangée de prises femelles du type à tulipe. La première rangée est composée d'une séquence de prises référencées E1, S1, E2, S2, . . . E28, S28, E29. La deuxième rangée comporte la séquence E'1, S'1, E'1, . . ., E'28, S'28, E'29. L'alimentation VC est raccordée sur les bornes E' de rang impair de la seconde rangée ainsi qu'à la borne E29 et le potentiel masse est raccordé aux bornes E' paires de cette deuxième rangée ainsi qu'à la borne E1. Les bornes B2 à B28 d'entrée sont respectivement reliées aux bornes E2 à E28 de la première rangée. Les bornes S et S' de même rang des deux rangées sont reliées ensemble; les bornes S1 à S28 sont connectées vers les bornes de sortie de CFS1 à CFS5 de la manière suivante: les parties CFS1, CFS3 et CFS5 comportent chacune 20 bornes reliées respectivement aux bornes S1 à S20 de la matrice de commutation MC. En ce qui concerne les deux autres parties CFS2 et CFS4, elles sont reliées par leur huit premières broches aux bornes S21 à S28 de la matrice MC et par leurs douze autres bornes aux bornes S9 à S21 de la matrice MC.

Le rôle de la matrice de commutation MC est de distribuer les signaux nécessaires (au plus 28) sur la conncection EC de la carte mère qui a été décrite précédemment à l'aide des figures 7 et 8, et d'adapter cette distribution à toutes les combinaisons possibles de brochage des circuits intégrés. La matrice de commutation MC a les bornes disposées de manière équidistantes entre elles au pas standard de 1/10 de pouce sur chaque rangée et il faut considérer également que des cavaliers de court-circuit correspondant à cette distance de 1/10 de pouce sont prévus pour effectuer les raccordements utiles. Chaque cavalier CV permet de réunir deux bornes voisines d'une même rangée. Chacune des sorties S1 à S28 de la matrice de commutation est normalement raccordée par un cavalier CV à la borne voisine correspondant au signal à recevoir sur cette borne, par exemple la borne S1 reliée par un cavalier CV1 à la borne E2 reçoit le signal de la borne B2 de CFE, et ainsi de suite. La borne S1 peut être reliée par le cavalier à E1 pour se trouver connectée à la masse (où S'1 reliée par le cavalier à E'2); enfin si la liaison par cavalier est établie entre S'1 et E'1, la borne S1 est connectée à la tension +VC. Ainsi toutes options sont possibles pour chaque point actif, la transmission normale d'un signal dynamique ou son remplacement par l'un des deux potentiels continus d'alimentation reçus de B1 ou de B29. Il est ainsi possible d'adapter le plateau en fonction des différents types de circuits intégrés.

L'ensemble de la connectique carte fille et carte mère décrite à l'aide des Figures 8 et 9 permet d'alimenter en parallèle les broches de même numéro des circuits intégrés associés par un même signal (stimuli ou alimentation) dans les trois cas de présentation envisagés (Figure 7a, Figure 7b et Figure 7c).

Moyennant un montage adaptateur conçu pour être enfiché sur les prises à tulipe et servir d'embase pour des circuit intégrés particuliers, le dispositif peut être utilisé pour traiter encore ces autres types de circuits intégrés, par exemple des circuits à boîtier rond TO-5 ou TO-100.

Il y a lieu de remarquer que grâce à un circuit de protection et d'adaptation PAj et à la matrice de commutation MC, le plateau peut être utilisé pour traiter des circuits intégrés à alimentation multiples. A titre d'exemple, en disposant d'une seconde tension d'alimentation VC1 amenée sur une des broches B2 à B28 à la place d'un signal dynamique, on produit, grâce au montage R1—R2 et à la tension VC, un potentiel désiré au point commun pour alimenter des broches correspondantes des circuits intégrés associés.

Un dispositif support de circuits intégrés conforme à l'invention permet de réaliser économiquement des opérations de sélection de circuits intégrés qui sont nécessaires dans les industries de télécommunications, de l'équipement automobile, de l'avionique ou dans les domaines du spatial, de l'électronique médicale et des applications militaires. Il assure une grande souplesse dans le traitement d'une grande variété de circuits et permet également un traitement d'une grande efficacité puisque portant sur un nombre optimal de signaux dynamiques appliqués à ces circuits.

Le dispositif support décrit correspond à une réalisation préférée car ne comportant qu'un seul modèle. En contrepartie, les circuits imprimés sont assez complexes our répondre aux trois différents types de boîtier de circuits intégrés. On peut se rendre compte qu'une variante intermédiaire consiste à simplifier les circuits imprimés moyennant cette fois l'obligation inverse d'avoir à gérer plusieurs modèles de plateaux. Ces divers plateaux restent toutefois en nombre très réduit puisque deux ou trois types suffisent. Dans le cas de trois modèles, les plateaux sont équipés de prises femelles à tulipe ou d'embases correspondant respectivement aux trois types d'écartement de circuits intégrés, c'est-à-dire qu'il n'y a que deux rangées de prises par modèle. Une version à deux modèles résulte en partie de la solution optimale décrite puisque l'un des modèles comporte trois rangées pour recevoir deux types de circuits intégrés, par exemple ceux d'écartement 4 ou 6/10 de pouce. De telles variantes sont à considérer incluses dans l'invention étant donné qu'elles répondent à un même esprit de simplification de plateaux et d'amélioration des performances avec notamment les possibilités indiquées d'agir sur toutes les broches du circuit imprimé et d'effectuer les commutations de signaux nécessitées par le brochage à réaliser.

**Revendications**

1. Dispositif support de circuits intégrés, utilisé dans un système de sélection de circuits à haute fiabilité en fonction de contraintes thermiques et dynamiques prédéterminées, le dispositif support étant constitué de plusieurs plateaux pour recevoir respectivement des circuits intégrés dont le nombre de broches peut différer et pour réaliser des connexions d'interface assurant le raccordement en parallèle des broches de même numéro, chaque plateau comportant une carte mère et une pluralité P de cartes filles sur lesquelles le circuit d'interconnexion est réalisé en circuit imprimé, la carte mère étant en circuit double face dotée sur une face d'une première série d'embases pour recevoir les cartes filles et d'une deuxième série d'embases pour recevoir des circuits intégrés, les circuits imprimés étant déterminés en sorte que le plateau comporte P groupes, chaque groupe étant formé d'une carte fille associée à une pluralité N de circuits intégrés lesquels peuvent être au total de P.N sur le plateau, les cartes filles comportant un circuit imprimé avec des éléments résistifs de protection des circuits intégrés, caractérisé en ce que les plateaux (PL) ont une structure quasi-universelle comportant au plus trois modèles en utilisant au plus trois types d'embase de circuits intégrés pour recevoir les différents boîtiers usuels de circuits intégrés répondant aux standards d'écartement 0,3 pouce (7,62 mm), 0,4 pouce (10,16 mm) et 0,6 pouce (15,24 mm) entre les deux rangées de broches et en réalisant les cartes filles (CF) en circuit imprimé multicouches.

2. Dispositif selon la revendication 1, caractérisé en ce qu'il comporte trois modèles de plateaux équipés chacun d'un type d'embase de circuit intégré correspondant à l'un desdits standards d'écartement.

3. Dispositif selon la revendication 1, caractérisé en ce qu'il comporte deux modèles de plateaux éqipés l'un, d'embases de circuits intégrés correspondant à un standard d'écartement et le deuxième, d'embases répondant aux deux autres standards, lesdites embases étant constitués par des rangées de prises femelles tronconiques du type à tulipe.

4. Dispositif selon la revendication 1, caractérisé en ce qu'il comporte un unique modèle de plateaux réalisé en utilisant pour former ladite deuxième série d'embases, des prises femelles tronconiques (Pij) dites à tulipe réparties sur quatre rangées en sorte que les écartements entre une première rangée et les deuxième, troisième et quatrième rangées correspondent respectivement aux trois standards d'écartement des circuits intégrés.

5. Dispositif selon l'une quelconque des revendications 1 à 4, caractérisé en ce que les circuits imprimés sont déterminés pour permettre de connecter séparément et activement toutes les broches des circuits intégrés à travers les cartes filles correspondantes depuis un connecteur unique (CNj) de raccordement extérieur du plateau (PLj).

6. Dispositif selon la revendication 4 ou selon les revendications 4 et 5, caractérisé en ce que l'arrangement des prises selon un module de base comporte quatorze prises (P1.1 à P1.14) sur la première rangée, dix (P2.1 à P2.10) sur la seconde, onze (P3.1 à P3.11) sur la troisième et quatorze (P4.1 à P4.14) sur la quatrième, pour recevoir respectivement des circuits intégrés d'écartement 0,3 pouce et ayant au plus 20 broches, des circuits en 0,4 pouce à 22 broches et des circuits en 0,6 pouce ayant 24 à 28 broches.

7. Dispositif selon la revendication 6, caractérisé en ce que les prises associées à une carte fille (CFij) comportent trois desdits modules de base (M28) ainsi que deux autres modules (M20) ayant deux rangées de dix prises écartées à 0,3 pouce en sorte de pouvoir traiter au total cinq circuits intégrés 0,3 pouce ou trois circuits intégrés d'écartement 0,4 ou 0,6 pouce.

8. Dispositif selon l'une quelconque des revendications 1 à 7, caractérisé en ce que les cartes filles comportent des moyens de protection et d'adaptation (PA) des circuits intégrés, constitués par un circuit (PAj) inséré dans chaque connexion de transmission de signal, ce circuit étant constitué par une première diode (D1) en série dans ladite connexion, l'anode côté entrée et la cathode côté sortie, deux résistances (R1 et R2) formant un pont diviseur entre une tension d'alimentation continue et la masse et dont le point commun est situé sur la connexion en aval de la diode côté sortie, et une deuxième diode (D2) connectée entre ce point commun et la masse, l'anode côté point commun.

9. Dispositif selon la revendication 8, caractérisé en ce que les cartes filles (CFj) sont réalisées au moyen d'un circuit imprimé ayant au moins trois couches et que les moyens de proctection et d'adaptation comportent en outre une matrice de commutation (MC) constituée par des prises femelles du type à tulipe et de moyens de connexion pour la transmission d'un signal dynamique, ou d'un potentiel d'alimentation continue, ou de masse, à chaque borne de chaque circuit intégré à sélectionner selon le brochage à réaliser.

10. Dispositif selon la revendication 9, caractérisé en ce que les prises de la matrice de commutation (MC) sont régulièrement réparties selon deux rangées, en sorte de produire lesdites connexions par un cavalier de court-circuit qui peut occuper plusiers positions différentes de raccordement.

11. Utilisation d'un dispositif support selon la revendication 5 et l'une quelconque des revendications 6 à 10 dans un système de sélection de circuits intégrés à haute fiabilité, caractérisé en ce que le système comporte des amplificateurs de puissance générateur des signaux dynamiques ou stimuli, en nombre égal à celui maximal des broches des circuits intégrés à sélectionner, ce nombre étant diminué du nombre de broches recevant les tensions d'alimentations continues.

**Patentansprüche**

1. Trägervorrichtung für integrierte Schaltkreise, angewendet in einem Auswahlsystem für bei vorbestimmten thermischen und dynamischen Beanspruchungen hochzuverlässige Schaltkreise, wobei die Trägervorrichtung aus mehreren Platten gebildet ist, um jeweils integrierte Schaltkreise aufzunehmen, bei denen die Anzahl von Anschlußstiften verschieden sein kann, und um Schnittstellenverbindungen herzustellen, welche die Parallelschaltung der Stifte gleicher Nummer gewährleisten, wobei jede Platte eine Hauptkarte und eine Mehrzahl P von Unterkarten aufweist, auf denen die Schaltungsverbindungen als gedruckte Schaltung hergestellt sind, wobei die Hauptkarte als doppelseitige Schaltung ausgebildet ist, welche auf einer Fläche eine erste Reihe von Sockeln zur Aufnahme der Unterkarten und eine zweite Reihe von Sockeln zur Aufnahme von integrierten Schaltkreise ausweist, wobei ferner die gedruckten Schaltungen derart ausgelegt sind, daß die Platte P Gruppen umfaßt, wovon jede aus einer Unterkarte gebildet ist, welche einer Mehrzahl von N von integrierten Schaltkreisen zugeordnet ist, von denen insgesamt P.N auf der Platte vorhanden sein können, und wobei die Unterkarten eine gedruckte Schaltung mit resistiven Schutzelementen für die integrierten Schaltkreise umfassen, dadurch gekennzeichnet, daß die Platten (PL) eine quasi-universelle Struktur aufweisen, die höchstens drei Modelle umfaßt, unter Verwendung von höchstens drei Sockeltypen für integrierte Schaltkreise, um die verschiedenen üblichen Gehäuse von integrierten Schaltkreisen aufzunehmen, die den Abstandsnormen 0,3 Zoll (7,62 mm), 0,4 Zoll (10,16 mm) und 0,6 Zoll (15,24 mm) zwischen den zwei Reihen von Stiften entsprechen, wobei die Unterkarten (CF) als mehrschichtige gedruckte Schaltung ausgebildet sind.

2. Vorrichtung nach Anspruch 1, dadurch gekennzeichnet, daß sie drei Modelle von Platten umfaßt, die jeweils mit einem Sockeltyp für integrierte Schaltungen ausgestattet sind, welcher einer der genannten Abstandsnormen entspricht.

3. Vorrichtung nach Anspruch 1, dadurch gekennzeichnet, daß sie zwei Modelle von Platten umfaßt, von denen das eine mit Sockeln für integrierte Schaltkreise ausgestattet ist, die einer Abstandsnorm entsprechen, und das andere mit Sockeln ausgestattet ist, welche zwei anderen Normen entsprechen, wobei die genannten Sockel durch Reihen von kegelstumpfförmigen oder tulpenförmigen Aufnahmeteilen gebildet sind.

4. Vorrichtung nach Anspruch 1, dadurch gekennzeichnet, daß sie ein einziges Plattenmodell umfaßt, das zur Bildung der zweiten Reihe von Sockeln unter Verwendung von kegelstumpfförmigen (Pij) Aufnahmeteilen vom sogenannten Tulpentyp verwirklicht ist, welche auf vier Reihen verteilt sind, dergestalt, daß die Abstände zwischen einer ersten Reihe und der zweiten, dritten und vierten Reihe jeweils den drei Abstandsnormen der integrierten Schaltkreise entsprechen.

5. Vorrichtung nach einem der Ansprüche 1 bis 4, dadurch gekennzeichnet, daß die gedruckten Schaltungen derart ausgelegt sind, daß sie ein getrenntes und aktives Anschließen aller Stifte der integrierten Schaltkreise über die entsprechenden Unterkarten über einen einzigen Anschlußverbinder (CNj) außerhalb der Platte (PLj) gestattet.

6. Vorrichtung nach Anspruch 4 oder nach den Ansprüchen 4 und 5, dadurch gekennzeichnet, daß die Anordnung der Aufnahmeteile bei einem Grundmodul vierzehn Aufnahmeteile (P1.1 bis P1.14) in der ersten Reihe, zehn (P2.1 bis P2.10) in der zweiten, elf (P3.1 bis P3.11) in der dritten und vierzehn (P4.1 bis P4.14) in der vierten Reihe umfaßt, um jeweils integrierte Schaltkreise aufzunehmen, bei denen der Abstand 0,3 Zoll beträgt und die höchstens 20 Stifte aufweisen, bzw. Schaltkreise mit 0,4 Zoll und 22 Stiften bzw. Schaltkreise mit 0,6 Zoll und 24 bis 28 Stiften aufzunehmen.

7. Vorrichtung nach Anspruch 6, dadurch gekennzeichnet, daß die einer Unterkarte (CFij) zugeordneten Aufnahmeteile drei der genannten Grundmoduln (M28) sowie zwei weitere Moduln (M20) umfassen, die zwei Reihen von zehn Aufnahmeteilen aufweisen, deren Abstand 0,3 Zoll beträgt, so daß insgesamt fünf integrierte Schaltkreise zu 0,3 Zoll oder drei integrierte Schaltkreise mit dem Abstand 0,4 oder 0,6 Zoll verarbeitet werden können.

8. Vorrichtung nach einem der Ansprüche 1 bis 7, dadurch gekennzeichnet, daß die Unterkarten Schutz- und Anpassungsmittel (PA) für die integrierten Schaltkreise umfassen, welche aus einer Schaltung (PAj) gebildet sind, die in jede Signalübertragungsverbindung eingefügt ist, wobei diese Schaltung aus einer ersten, mit der genannten Verbindung in Reihe liegenden Diode (D1), deren Anode eingangsseitig und Katode ausgangsseitig angeordnet ist, zwei Widerständen (R1 und R2), die eine Teilerbrücke zwischen einer Versorgungsgleichspannung und der Masse bilden und deren gemeinsamer Punkt auf der im Signalweg hinteren Verbindung der Diode ausgangsseitig liegt, und aus einer zweiten Diode (D2) gebildet ist, welche zwischen diesen gemeinsamen Punkt und Masse geschaltet ist und deren Anode auf der Seite des gemeinsamen Punktes liegt.

9. Vorrichtung nach Anspruch 8, dadurch gekennzeichnet, daß die Unterkarten (CFj) mittels einer gedruckten Schaltung verwirklicht sind, die wenigstens drei Schichten umfaßt, und daß die Schutz- und Anpassungsmittel ferner eine Schaltmatrix (MC) umfassen, welche aus Aufnahmeteilen vom Tulpentyp und Verbindungsmitteln gebildet ist, für die Übertragung eines dynamischen Signals, eines Versorgungs-Gleichpotentials oder Massepotentials zu jedem Anschluß jedes integrierten Schaltkreises, der je nach der herzustellenden Schaltverbindung auszuwählen ist.

10. Vorrichtung nach Anspruch 5, dadurch gekennzeichnet, daß die Aufnahmeteile der Schaltmatrix (MC) regelmäßig auf zwei Reihen derart verteilt sind, daß die genannten Verbindungen durch einen Kurzschlußreiter hergestellt werden, der mehrere verschiedene Verbindungsstellungen einnehmen kann.

11. Verwendung einer Trägervorrichtung nach Anspruch 5 und einem der Ansprüche 6 bis 10 in einem Auswahlsystem für hochzuverlässige integrierte Schaltkreise, dadurch gekennzeichnet, daß das System Leistungsverstärker zur Erzeugung von dynamischen Signalen oder Stimulierungssignalen enthält, deren Anzahl der maximalen Anzahl von auszuwählenden Anschlußstiften der integrierten Schaltkreise entspricht, wobei diese Anzahl vermindert ist um die Anzahl von Anschlußstiften, die Versorgungsgleichspannungen empfangen.

**Claims**

1. Integrated circuit carrier device used in a system for the selection of highly reliable circuits as a function of predetermined thermal and dynamic stresses, the carrier device being constituted by a plurality of plates for receiving respectively integrated circuits, the number of pins of which may differ, and for establishing interface connections insuring the parallel connection of the pins of the same number, each plate comprising a main board and a plurality P of auxiliary boards on which the interconnection circuit is formed as printed circuit, the main board being a double-face circuit equipped on one face with a first series of sockets for receiving the auxiliary boards and a second series of sockets for receiving the integrated circuits, the printed circuits being defined in such a manner that the plate comprises P groups, each group being formed by an auxiliary board associated with a plurality N of integrated circuits of which a total of P.N made be on the plate, the auxiliary boards comprising a printed circuit with resistive protective elements for the integrated circuits, characterized in that the plates (PL) have a quasi-universal structure comprising at the most three models employing at the most three types of integrated circuit sockets for receiving the different usual housings of integrated circuits corresponding to the spacing standards 0.3 inch (7.62 mm), 0.4 inch (10.16 mm) and 0.6 inch (15.24 mm) between the two rows of pins, and forming the auxiliary boards (CF) as multi-layer printed circuit.

2. Device according to claim 1, characterized in that it comprises three models of plates each equipped with one integrated circuit socket type corresponding to one of said spacing standards.

3. Device according to claim 1, characterized in that it comprises two models of plates one equipped with integrated circuit sockets corresponding to a spacing standard and the second with sockets corresponding to the two other standards, said sockets being constituted by rows of truncated conical female connector members of tulip type.

4. Device according to claim 1, characterized in that it comprises a single plate model realized using to form said second series of sockets truncated conical (Pij) female connector members of the so called tulip type distributed amongst four rows in such a manner that the spacings between a first row and the second, third and fourth rows correspond respectively to the three spacing standards of the integrated circuits.

5. Device according to any one of claims 1 to 4, characterized connector printed circuits are defined to permit separate and active connection of all the pins of the integrated circuits through the corresponding auxiliary boards from a single connector (CNj) outside the plate (PLj).

6. Device according to claim 4 or claims 4 and 5, characterized in that the arrangement of the connector members according to a base module comprises fourteen connector members (P1.1 to P1.14) in the first row, ten (P2.1 to P2.10) in the second, eleven (P3.1 to P3.11) in the third and fourteen (P4.1 to P4.14) in the fourth row to receive respectively integrated circuits of 0.3 inch spacing having at the most 20 pins, 0.4 inch circuits having 22 pins and 0.6 inch circuits having 24 to 28 pins.

7. Device according to claim 6, characterized in that the connector members associated with an auxiliary board (CFij) comprise three of said base modules (M28) and two further modules (M20) having two rows of ten connector members with a 0.3 inch spacing thus making it possible to treat a total of five 0.3 inch integrated circuits or three integrated circuits of 0.4 or 0.6 inch spacing.

8. Device according to any one of claims 1 to 7, characterized in that the auxiliary boards comprise protection and adaptation means (PA) for the integrated circuits constituted by a circuit (PAj) inserted into each signal transmission connection, said circuit being constituted by a first diode (D1) in series in said connection, with input-side anode and output-side cathode, two resistors (R1 and R2) forming a dividing bridge between a supply dc voltage and ground, and the common point of which lies on the rear connection, in the signal path, of the diode on the output side, and a second diode (D2) connected between said common point and ground, the anode thereof lying on the side of the common point.

9. Device according to claim 8, characterized in that the auxiliary boards (CFj) are realized by means of a printed circuit having at least three layers and that the protection and adaptation means further comprise a switching matrix (MC) which is formed from connector members of the tulip type and connecting means for transmission of a dynamic signal, or of a supply dc potential or ground potential to each terminal of an integrated circuit selected in accordance with the switchung connection to be established.

10. Device according to claim 5, characterized in that the connector members of the switching matrix (MC) are regularly distributed amongst two rows so as to establish said connections by a sort-circuit rider which can occupy a plurality of different connection positions.

11. Use of a carrier device according to claim 5 and any one of claims 6 to 10 in a system for the selection of highly reliable integrated circuits, characterized in that the system comprises power amplifiers for generating dynamic signals of stimulating signals whose number is equal to the maximum number of pins to be selected of the integrated circuits, said number being reduced by the number of pins receiving dc supply voltages.

FIG_1

# FIG_2

# FIG_3

# FIG_4

# FIG_5

EO3           EO2          EO1          CNj

EF31      EF21      EF11

a   b   c   d

EC

EF32

EF35      EF25      EF15

# FIG_6

M20    M22       M20

M28

M48

# FIG_7

M48a         M48b         M28

7·a    | CI1 |   | CI2 |     | CI3 |   | CI4 |     | CI5 |

M20a     M20b      M20C     M20d      M20C

7·b    | CI1 |   M22a       | CI2 |   M22b    M22c   | CI3 |

7·c    | CI1 |   M28a       | CI2 |   M28b    M28c   | CI3 |

FIG_8

EO

EFij

CFij

M20b

M20d

M20e

M20a

M20c

M28c

M28a

M28b

**FIG_9**

0 070 225

19